**Europäisches Patentamt**

**European Patent Office**

**Office européen des brevets**

(19)

(11) Publication number : **0 443 668 B1**

(12) # EUROPEAN PATENT SPECIFICATION

(45) Date of publication of patent specification :
22.06.94 Bulletin 94/25

(51) Int. Cl.⁵ : **H03D 9/06, H03D 7/18**

(21) Application number : **91200312.6**

(22) Date of filing : **14.02.91**

(54) **Image rejection frequency converter provided in planar technology.**

(30) Priority : **21.02.90 IT 1943390**

(43) Date of publication of application :
**28.08.91 Bulletin 91/35**

(45) Publication of the grant of the patent :
**22.06.94 Bulletin 94/25**

(84) Designated Contracting States :
**CH DE ES FR GB GR IT LI SE**

(56) References cited :
**EP-A- 0 193 849**
**PATENT ABSTRACTS OF JAPAN vol. 12, no. 362 (E-663)September 28, 1988 & JP-A-63 115 404 (NEC CORP ) May 20, 1988**

(56) References cited :
**MICROWAVE JOURNAL. vol. 29, no. 9, September 1986, NORWOOD, MASSACHUSETTS, USA pages 161 - 175; CHANDRA GUPTA ET AL.: 'DESIGN OF MICROSTRIP RECEIVER SUPERCOMPONENTS AT MM-WAVE FREQUENCIES" '**
**IEEE MTT-S INTERNATIONAL MICROWAVE SYMPOSIUM DIGEST vol. 1, June 13, 1989, NEW YORK, USA pages 967 - 968; DAVID CAHANA: 'A NEW COPLANAR WAVEGUIDE / SLOTLINE DOUBLE BALANCED MIXER '**
**MICROWAVE SYSTEM NEWS, VOL. 17(9) 1987, PAGES 75-78,80,82,83, PALO ALTO,CALIFORNIA, US BERT C. HENDERSON AND JAMES A. COOK: "IMAGEREJECT AND SINGLE-SIDEBAND MIXERS"**
**11TH EUROPEAN MICROWAVE CONFERENCE PROCEEDINGS, 1981, PAGES 203-208**

(73) Proprietor : **SIEMENS TELECOMUNICAZIONI S.P.A.**
**SS. 11 Padana Superiore Km. 158**
**I-20060 Cassina de Pecchi (Milano) (IT)**

(72) Inventor : **Volpicella, Nicola**
**Via delle Magnolie, 6/A**
**I-20060 Cassina de' Pecchi (Milano) (IT)**

EP 0 443 668 B1

Jouve, 18, rue Saint-Denis, 75001 PARIS

## Description

The present invention relates to the field of frequency conversion and more specifically to an image rejection frequency converter in planar technology operating in the microwave range.

Frequency converters of the general type are employed as is known in transmitters and receivers of radiofrequency signals for the main purpose of translating the entire band of modulated signals to a frequency better suited to transmission or reception.

In transmission the converter is generally an up-converter and the following relationship applies:

$$fRF = fLO \pm fIF$$

where fRF is the radiofrequency output signal from the converter, fLO is the frequency of the local oscillator signal and fIF is the intermediate frequency signal which reaches an input of the converter.

As may be seen from the formula, at the output of the converter two distinct frequency bands symmetrically arranged in relation to the frequency fLO are achieved. The band corresponding to the + sign is termed 'upper side band' while the one corresponding to the - sign is termed 'lower side band'. Generally only one of the two side bands constitutes the useful signal while the other is eliminated by means of a special radiofrequency filtering for the dual purpose of reducing band occupation and saving transmission power.

In reception the converter is a down-converter and for the signal fIF produced at the output the following relationship applies.

$$fIF = \mid fLO - fRF \mid$$

As may be seen from the above formula there are two distinct frequency bands belonging to the radiofrequency signal fRF which can generate the same intermediate frequency signal fIF. Similarly to what was said above, of these two frequency bands one belongs to the useful signal and the other is termed 'image band'.

It is appropriate to eliminate the image band by special radiofrequency filtering, mainly to avoid the signal and noise in said band getting converted also in the intermediate band and causing superimposition or contributing to worsening of the characteristics of the receiver.

The converters mentioned above belong to a first type of converter termed 'double side band'.

As is known there is a second type of frequency converter which differs from the first type in that it uses a particular circuit configuration which makes it possible to use a single side band without the aid of a special filter at the radiofrequency signal port. These converters are termed 'single side band' or image rejection or image suppression converters.

The benefits of image rejection converters as compared to conventional converters are obvious. Indeed, the latter require an image filter which makes the radio system costlier, cumbersome and with poor flexibility of application.

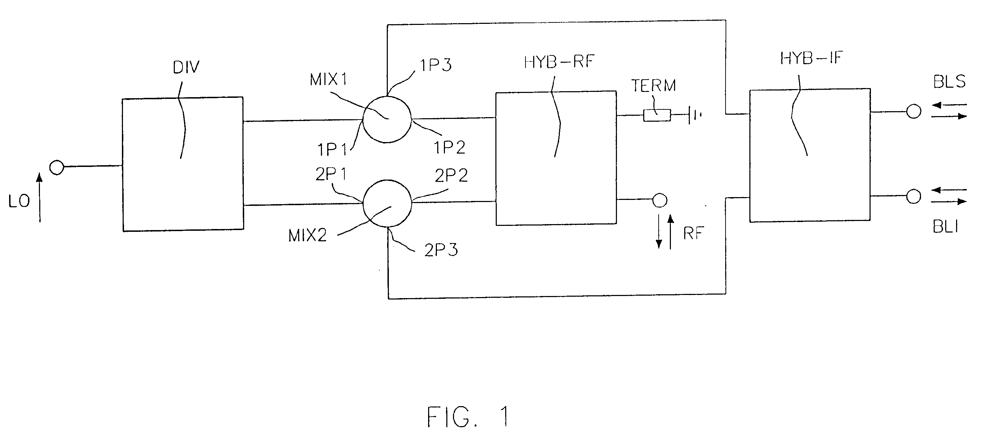

The most general circuit configuration used in image rejection converters of the known type is shown in FIG. 1. It comprises:

- a first power divider indicated by the symbol DIV which couples a local oscillator signal LO to first ports 1P1, 2P1 of two frequency mixers MIX1, MIX2.

With converters in which the local oscillator signal LO is not balanced with the ground potential the power divider DIV is a balun because it converts the unbalanced signal LO into two signals balanced with the ground potential, coupling them to the ports 1P1 and 2P1.

- A second power divider HYB-RF with in quadrature outputs which, in the case of the converter used in reception, couples the radiofrequency signal of reception RF, also comprising the image band, to second ports 1P2, 2P2 of said mixers MIX1, MIX2.
- A third power divider HYB-IF with in quadrature outputs which, in the above hypothetical cases, receives on two inputs the respective beating between RF and LO with intermediate frequency coming from third ports 1P3, 2P3 of said mixers MIX1, MIX2 obtaining at one of its first outputs a signal BLS generated by the conversion of the upper side band of the signal RF and at a second point a signal BLI generated by the conversion of the lower side band of the signal RF. In the case of the converter used in transmission dual considerations apply.

A known variant on the above mentioned circuit configuration provides for the use of merely balanced mixers which require two duplexer filters which allow coupling of the radiofrequency signals RF and intermediate frequency signals BLS or BLI to a single port of the respective mixers MIX1, MIX2.

The configuration of FIG. 1 can be embodied either with mechanical wave guide technology or with the more modern thin film planar technology. In both cases to obtain converters having good operating characteristics special care in designing the baluns is essential.

A particularly significant article as concerns the theory of the above power dividers is the one entitled "A Printed Circuit Balun for Use with Spiral Antennas" by R. Bawer and J. J. Wolfe and published in IRE Transactions MTT-8, pages 319-325, May 1960.

The state of the art includes different examples of image rejection converters provided in planar technology operating in the microwave range, each having its own original embodiment of the balun.

A first converter structure is described in the article entitled "Single side band mixers for communications systems" by Ben R. Hallford and published in IEEE MTT-S DIGEST in 1982.

The greatest drawback of the converter described is due to the fact that the square structure which is proposed is quite cumbersome, especially because of the size of the baluns.

A second structure is described in the article entitled "MIC image-reject and enhancement mixers for radio link applications" by Ulrich H. Gysel and published in the 11th European Microwave Conference Proceedings, 1981, pages 203-208.

The main drawback of the converter described is that it has a narrow operating band. In addition the structure is cumbersome, especially in the embodiment operating at the lowest frequencies allowed by the technology employed.

A third structure is described in patent application DE-P3804926.0 dated 17 February 1988 filed by SIEMENS AG and entitled "Single side band mixer in microstrip technology".

The structure of the converter is specifically aimed at suppression of the harmonics of the local oscillator and, in this case also, is cumbersome.

Accordingly the object of the present invention is to overcome the above drawbacks and indicate an image rejection frequency converter provided in planar technology comprising essentially an integrated power divider with a balun which couples a local oscillator signal to the ends of two frequency mixers having ports to which arrive, or from which leave, radiofrequency signals and intermediate frequency signals.

The converter possesses a characteristic configuration provided in microstrip and in coplanar line which allows the power divider to convert a local oscillator signal not balanced with ground potential into a balanced signal for coupling to the ends of the mixers, preventing their appearing at the ports of the mixers affected by the radiofrequency and intermediate frequency signals.

To achieve these purposes the object of the present invention is an image rejection frequency converter provided in planar technology as described in claim 1.

The structure of the converter which is the object of the invention is more compact and has several advantages.

A first advantage is that it can be used even with relatively low frequencies on the order of 500MHz to 1GHz.

A second advantage is that it makes possible achieving a large pass band which with special construction arrangements can be extended to three octaves.

A third advantage is its construction simplicity.

Other objects and advantages of the present invention will be made clear by the following detailed description of an example of embodiment thereof and the annexed drawings given merely for purposes of clarification and nonlimiting wherein:

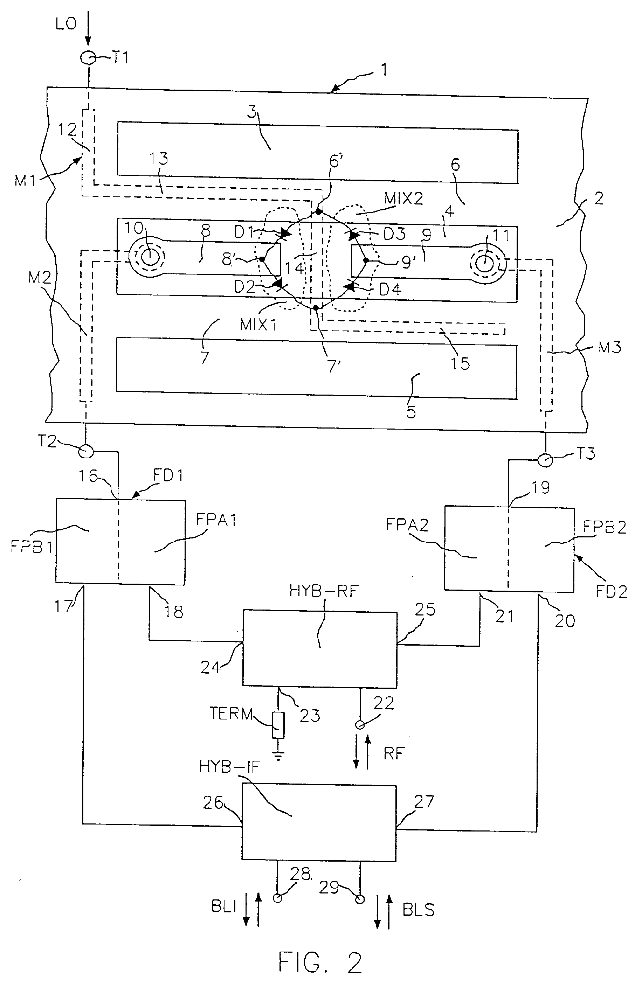

FIG. 2 shows an overall view of the image rejection converter which is the object of the present invention. The view includes a circuit part and four function blocks connected together and to said circuit part.

The dimensions of the circuit elements shown in FIG. 2, as the distances, do not correspond exactly to the effective ones because the figure is given merely for illustrative purposes.

With reference to FIG. 2 where the same elements as in FIG. 1 are indicated by the same symbols, reference number 1 indicates an insulating substrate, e.g. alumina, having on the upper face an extended metallization 2.

The metallization 2 acts as a ground plane and leaves uncovered three zones of the substrate 1 rectangular in form and indicated by numbers 3, 4, and 5. Said rectangular zones have the same length and are aligned one under the other. The central zone 4 is at exactly one half the distance in relation to the outer zones 3 and 5.

Between the central zone 4 and the two outer zones 3 and 5, because of the distance between them, two metallizaton strips are included and form two lines 6 and 7 of equal length.

The central zone 4 on the same face of the ground plane 2 includes two metallized lines 8 and 9 parallel to the lines 6 and 7. The lines 8 and 9 cover almost entirely the zone without metallization 4 except for a small central portion. The outer end of the lines 8 and 9 included two metallized holes indicated respectively by 10 and 11.

Near the central portion of the zone 4 on the same face of the metallization 2 can be seen two pairs of diodes in series D1, D2 and D3, D4, said pairs being connected in parallel. The pair of diodes D1 and D2 forms a first mixer MIX1. The pair of diodes D3 and D4 forms a second mixer MIX2.

More precisely, the diode D1 has its anode connected to the line 6 at point 6′ and the cathode connected to the line 8 at point 8′. The diode D2 has the anode connected to the line 8 at point 8′ and the cathode connected to the line 7 at point 7′. The diode D3 has the cathode connected to the line 6 at point 6′ and the anode connected to the line 9 at point 9′. The diode D4 has its cathode connected to the line 9 at point 9′ and the anode connected to the line 7 at point 7′.

The face of the substrate 1 opposite that of the ground plane 2 includes three metallization lines indicated by M1, M2 and M3 which, together with the ground plane 2, form three microstrip lines.

The microstrip line M1 is composed of four contiguous line sections indicated by 12, 13, 14 and 15.

The first section 12 has one end connected to a terminal T1 to which arrives the local oscillator signal LO. The other end is connected to the horizontal line section 13.

The section 13 is placed in correspondence with the line 6 and extends half the length thereof and continues in the vertical section 14 located adjacent to the central portion of the rectangular zone 4.

The line section 14 is connected to the horizontal line section 15. The section 15 is placed opposite the line 7 and extends in the same direction as the section 13 for a length slightly less than that of said section 13.

The microstrip line M2 connects through the metallized hole 10 the line 8 to a terminal T2.

The microstrip line M3 connects through the metallized hole 11 the line 9 to a terminal T3.

The terminal T2 is connected to a first port 16 of a first duplexer filter FD1 formed of a low-pass section FPB1 and a high-pass section FPA1. The high-pass section FPA1 is connected to the port 16 and to a second port 18 while the low-pass section is connected to the port 16 and to a third port 17.

The terminal T3 is connected to a first port 19 of a second duplexer filter FD2 identical to the first one and formed of a low-pass section FPB2 and a high-pass section FPA2. The high-pass section FPA2 is connected to the port 19 and to a second port 21, the low-pass section is connected to the port 19 and to a third port 20.

The duplexer filters FD1 and FD2 are provided in accordance with known techniques which use concentrated or distributed elements.

The converter of FIG. 2 includes the in quadrature hybrid circuits HYB-RF and HYB-IF, operating on radiofrequency and intermediate frequency respectively.

Said hybrid circuits are of known type. They have four ports indicated by 22, 23, 24, 25 and 26, 27, 28, 29 respectively.

Their operation is such that a signal at a general port is found again at the two opposite ports as a pair of half-power signals phase shifted by 90°.

No signal is present at the port opposite the signal application port.

At one port (22) of the radiofrequency hybrid HYB-RF there is the radiofrequency signal RF and the double arrow indicates that the signal can be entering or leaving depending on whether the converter is used for reception or transmission. The adjacent port 23 is closed on a termination TERM connected to ground.

The ports 24 and 25 of HYB-RF are connected to the second ports 18 and 21 of the filters FD1 and FD2 belonging to the high-pass sections FPA1 and FPA2.

At the ports 28 and 29 of HYB-IF are present the intermediate frequency signals BLI and BLS respectively. The double arrow indicates that the signals can be incoming or outgoing depending on the fact that the converter is used for transmission or reception.

The ports 26 and 27 of the intermediate frequency hybrid HYB-IF are connected to the third ports of the filters FD1 and FD2 which correspond to the low-pass sections FPB1 and FPB2.

In operation the two mixers MIX1 and MIX2 are supplied by the local oscillator signal LO by means of the microstrip line M1. Therefore the signal LO input at the terminal T1 is not balanced with the ground potential.

The sections 13, 14 and 15 of M1 associated with the lines 6 and 7 function as baluns for the signal LO. For this purpose the structure shown in FIG. 2 possesses the following characteristics.

- The lines 6 and 7 are $\lambda/2$ long at the frequency of the signal LO.
- The section 13 of M1 is $\lambda/4$ long at the frequency of the signal LO.
- The section 15 and part of the section 14 of M1 form an open stub approximately $\lambda/4$ long at the frequency of the signal LO.
- It is best that the ratio of the width of the lines 6 and 7 to that of M1 be greater than 3. Under these conditions the microstrip M1 can be sufficiently decoupled from the lines 8 and 9.
- The points 6' and 7' of the lines 6 and 7 are points in which the local oscillator signal is balanced with the ground potential. Therefore there are present two sinusoidal signals with half power phase shifted 180° apart.
- The width of the sections 13 and 15 of M1 is determined to adapt the impedance of the unbalanced line M (50 ohm) to that of the balanced load consisting of the pairs of diodes of the mixers MIX1 and MIX2 and allowing achievement at the same time of a considerable operating bandwidth for the balun.

The radiofrequency signals RF and intermediate frequency signals BLS and/or BLI reach or come from the mixers MIX1 and MIX2 through the microstrips M2, M3 and the coplanar lines formed by the lines 8 and 9 with the lines 6 and 7. The transition from microstrip to coplanar takes place for said signals through the metallized holes 10 and 11.

The width of the lines 8 and 9 and their distance from the lines 6 and 7 are such as to achieve a characteristic impedance for said coplanar lines identical to that (50 ohm) of the microstrips M2 and M3.

For a converter used for reception the signal RF received is divided by the hybrid HYB-RF in two radiofrequency signals mutually phase shifted 90°. Said signals pass through the high-pass sections of the duplexer filters FD1 and FD2 to reach in the manner indicated above the mixers MIX1 and MIX2. More specifically, between the points 8' and 6' and between the points 8' and 7' of the mixer MIX1, there is a first radiofrequency signal. Between the points 9' and 6' and between the points 9' and 7' of MIX2 there is the second radiofrequency signal.

By the effect of the symmetrical configuration of the coplanar lines 8, 6, 7 and 9, 6, 7 the points 6' and 7' are equipotential for the radiofrequency and intermediate frequency signals.

The local oscillator signal LO sends alternately in conduction the pair of diodes D1, D2 and D3, D4 which generate a first and a second intermediate frequency beat signal.

Said intermediate frequency signals travel backward over the same path travelled by the radiofrequency signals, reach the terminals T2 and T3, then pass through the low-pass section of the filters FD1 and FD2 and reach the ports 26 and 27 of the hybrid HYB-IF. The latter recombines the above intermediate frequency signals which are in quadrature obtaining at the ports 28 and 29 the signals BLI and BLS which, as mentioned, correspond to the conversion to intermediate frequency of the lower and upper side bands respectively of the RF signal.

From the foregoing the need for the duplexer filters FD1 and FD2 appears clear. Indeed they actuate the separation of the radiofrequency signals RF and intermediate frequency signals BLS and/or BLI which are simultaneously present at the terminals T2 and T3.

The considerations made concerning the converter in reception apply to transmission operation.

In both cases the ports of the mixers are defined as follows.

The points 6′ and 7′ identify an application port of the signal LO common to the two mixers MIX1 and MIX2.

The points 8′ and 6′, 7′ considered together identify a first port of the mixer MIX1 to which arrive, or from which depart, the first radiofrequency signals and intermediate frequency signals.

The points 9′ and 6′, 7′ considered together identify a second port of the mixer MIX2 to which arrive, or from which depart, the second radiofrequency signals and intermediate frequency signals.

The ports of the converters, as mentioned above in relation to the input/output points of the signals, are the following:

The terminal T1 represents the input port of the local oscillator signal LO.

The port 22 of HYB-RF is the radiofrequency port for the signal RF.

The ports 28 and 29 of HYB-IF are the intermediate frequency ports for the signals BLI and BLS.

The structure of the converter which is the object of the invention allows optimal insulation between the local oscillator port and the radiofrequency port.

Indeed the RF signal is not propagated toward he terminal T1 because the balun allows propagation toward T1 of the radiofrequency signals only if they are in phase opposition at points 6′ and 7′. As mentioned above the points 6′ and 7′ are equipotential for the radiofrequency signals.

Reciprocally, the local oscillator signal LO present at the terminal T1 does not appear on the microstrips M2 and M3 and hence at the radiofrequency port 22.

Indeed the lines 8 and 9, because of their symmetrical arrangement in the circuit and their connections to the diodes of the mixers, take on an intermediate potential in relation to that of the lines 6 and 7. Said potential is null for the signal LO because it is balanced with ground.

Therefore the structure of the converter possesses the advantage, particularly useful in transmission, of avoiding costly filters capable of attenuating the local oscillator signal.

Another advantage is due to the fact that the planar structure allows integration on a single substrate 1 even of the duplexer filters FD1, FD2 and of the hybrid circuits HYB-RF, HYB-IF, providing a smaller and highly functional converter.

## Claims

1. Image rejection frequency converter embodied in planar technology comprising:

   - a first and a second frequency mixer (MIX1,MIX2) each consisting of a pair of diodes (D1,D2, D3,D4) connected in series;
   - an input port (T1) for a local oscillator signal (LO), a first (T2) and a second port (T3) to which arrive or from which depart a first and a second radiofrequency signal respectively phase shifted 90° from each other and from which exit or to which arrive a first and/or a second intermediate frequency signal also phase shifted 90°;
   - means (M2,M3,8,9,6,7,10,11) which allow coupling of said radiofrequency signals and intermediate frequency signals to said first and second frequency mixers (MIX1, MIX2), and
   - a first microstrip line (M1) making up part of a balun, characterized in that in a ground plane (2) of said first microstrip line (M1) are made three rectangular zones of equal length (3,4,5) without metallization and aligned and parallel at an identical distance from each other and said distance forming two metallic lines of equal dimensions (6,7) between the central rectangular zone (4) and the two outer rectangular zones (3,5);

     in that said first microstrip line (M1) includes a first section (13) placed predominantly opposite a first (6) of said metallic lines of equal dimensions (6,7), said section joining the input port of the local oscillator (T1) with a second section (14) placed at half the length of said first metallic line (6) and forming a right angle with said first section (13), said second section (14) being further connected to a third section (15) placed adjacent to a second (7) of said metallic lines of equal dimensions continuing the direction of said first section (13);

in that the length of said first and second metallic lines (6,7) is $\lambda/2$ at the frequency of the local oscillator signal (LO) and that said first and second frequency mixers (MIX1,MIX2) are connected at the centre of said first and second lines (6,7);

in that said coupling means include a third and a fourth (8,9) metallic line placed inside of said central zone (4) without metallization, allowing achievement of lines coplanar with said first and second lines (6,7), said third and fourth metallic lines having first ends connected to said first and second frequency mixers (MIX1,MIX2) respectively at the central points of the series connection of the diodes (D1,D2 D3,D4) and second ends connected to a second and a third microstrip line (M2,M3) respectively joining said ends to the first and second port (T2,T3) respectively of said converter.

2. Image rejection frequency converter in accordance with claim 1 characterized in that said third section (15) plus part of said second section (14) of said first microstrip (M1) form an open stub $\lambda/4$ long at the frequency of the local oscillator signal (LO).

3. Image rejection frequency converter in accordance with claim 1 characterized in that the width of the first and third sections (13,15) of said first and third sections (13,15) of said first microstrip (M1) has a value such as to achieve matching of the characteristic impedance of said first microstrip with that resulting from the connection of the two mixers (MIX1,MIX2), to said first and second lines (6,7).

4. Image rejection frequency converter in accordance with claim 1 characterized in that the ratio of the widths of said first and second lines (6,7) to those of said first and third sections (13,15) of said microstrips (M1) has a value such as to allow decoupling of said first and third sections (13,15) from said third and fourth lines (8,9).

5. Image rejection frequency converter in accordance with claim 1 characterized in that the widths of said third and fourth lines (8,9) and their distance from said first and second lines (6,7) have a value such as to achieve a characteristic impedance of said coplanar lines (8,6,7 9,6,7) identical with that of said second and third microstrips (M2,M3).

6. Image rejection frequency converter in accordance with claim 1 characterized in that said balun includes said first and second lines (6,7) and said first, second and third sections (13,14,15) of the first microstrip (M1), allowing a local oscillator signal (LO), coupled to the respective input port (T1) not balanced with the ground potential, to be present on said first and second lines (6,7) balanced with the ground potential.

7. Image rejection frequency converter in accordance with claim 1 characterized in that connection of the second ends of said third and fourth metallic lines (8,9) to said second and third microstrip lines (M2,M3) is provided by means of metallized holes (10,11).

8. Image rejection frequency converter in accordance with claim 1 characterized in that said first and second radiofrequency signals mutually phase shifted by 90° reach or come out of said first and second ports (T2,T3) of the converter by means of a first 3dB in quadrature hybrid coupling circuit operating at radiofrequency (HYB-RF) and a first and a second duplexer filter (FD1,FD2) including a high-pass section (FPA1,FPA2) which allows passage of the radiofrequency signals and blocks the intermediate frequency signals, and a low-pass section (FPB1,FPB2) which allows passage of the intermediate frequency signal and blocks the radiofrequency signals.

9. Image rejection frequency converter in accordance with claim 8 characterized in that said first hybrid coupling circuit (HYB-RF) has a first port (22) at which arrive or from which exit a radiofrequency signal (RF), a second port (23) adjacent to the first and closed on a termination (TERM), a third and a fourth port (24,25) connected to the high-pass sections (FPA1,FPA2) respectively of said duplexer filters (FD1,FD2) to which arrive or from which exit said first and second radiofrequency signals mutually phase shifted by 90°.

10. Image rejection frequency converter in accordance with claim 1 characterized in that said first and second intermediate frequency signals phase shifted by 90° reach or exit from said first and second ports (T2,T3) of the converter by means of a second 3dB in quadrature hybrid coupling circuit operating at intermediate frequency (HYB-IF) and said duplexer filters (FD1,FD2).

11. Image rejection frequency converter in accordance with claim 10 characterized in that said second 3dB in quadrature hybrid coupling circuit (HYB-IF) has a first and a second port (28,29) adjacent to each other and to which arrive or from which exit a first and/or a second intermediate frequency signal (BLI,BLS), a third and a fourth port (26,27) connected to the low-pass sections (FPB1,FPB2) of said duplexer filters (FD1,FD2).

**Patentansprüche**

1. Frequenzumsetzer mit Beseitigung der Spiegelfrequenz in planarer Technologie, der folgendes enthält:
   - einen ersten und zweiten Frequenzmischer (MIX1, MIX2), der jeweils aus einem in Serie geschalteten Diodenpaar (D1,D2 und D3, D4) besteht;
   - ein Eingangstor (T1) für das Signal der örtlichen Taktversorgung (LO), einem ersten (T2) und zweiten Tor (T3), an dem jeweils ein erstes und zweites, gegenseititg um 90° phasenverschobenes RF-Signal ankommt oder abgeht, und an dem ein erstes und/oder zweites, ebenfalls um 90° phasenverschobenes ZF-Signal ankommt oder abgeht;
   - Schaltmittel (M2, M3, 8, 9, 6, 7, 10, 11), die eine Ankoppelung der genannten RF- und ZF-Signale an die genannten ersten und zweiten Mischer (MIX1, MIX2) erlauben, und
   - eine erste Mikrostrip-Leitung (M1) als Teil eines Symmetrierübertragers, **dadurch gekennzeichnet,** daß auf der Grundplatte (2) der genannten Mikrostrip-Leitung (M1) drei rechteckige Zonen gleicher Länge ohne Metallisierung (3,4,5) vorgesehen sind, die untereinander die gleiche Entfernung haben und parallel ausgerichtet sind, wobei die genannte Entfernung zwischen der rechteckigen Zentralzone (4) und den beiden äußeren rechteckigen Zonen (3,5) zwei metallische Leiterbahnen gleicher Abmessung bildet (6,7); daß die genannte erste Mikrostrip-Leitung (M1) einen ersten Abschnitt (13) enthält, der hauptsächlich gegenüber einer ersten (6) der genannten metallischen Leiterbahnen gleicher Abmessungen (6,7) angebracht ist, wobei der genannte Abschnitt das Eingangstor der örtlichen Taktversorgung (T1) mit einem zweiten Abschnitt (14) verbindet, der bei halber Länge der genannten metallischen Leiterbahn (6) angebracht ist und mit dem genannten ersten Abschnitt (13) einen rechten Winklel bildet, und wobei der genannte zweite Abschnitt (14) außerdem mit einem dritten Abschnitt (15) verbunden ist, der an die zweite (7) der genannten metallischen Leiterbahnen gleicher Abmessungen angrenzt und in der Richtung des genannten ersten Abschnitts (13) verläuft;

   daß die Länge der genannten ersten und zweiten metallischen Leiterbahn (6,7) bei der Frequenz der örtlichen Taktversorgung (LO) 1/2 Lambda beträgt und daß der genannte erste und zweite Mischer (MIX1, MIX2) mit der Mitte der genannten ersten und zweiten Leiterbahn (6,7) verbunden ist; daß die Koppelelemente eine dritte und vierte (8,9), innerhalb der genannten nicht metallisierten Zentralzone (4) angebrachte metallische Leiterbahn einschließen, wodurch Leiterbahnen entstehen, die mit der ersten und zweiten metallischen Leiterbahn (6,7) in der gleichen Ebene liegen, wobei ein Anschlußpunkt der genannten dritten und vierten metallischen Leiterbahn mit dem genannten ersten und zweiten Frequenzmischer (MIX1, MIX2), bzw. den Zentralpunkten der in Serie geschalteten Dioden (D1, D2, D3, D4) verbunden ist und wobei deren zweiter Anschlußpunkt mit einer zweiten und dritten Mikrostrip-Leitung (M2,M3) verbunden ist, die die genannten Anschlußpunkte jeweils mit dem ersten und zweiten Tor (T2,T3) des genannten Umsetzers verbinden.

2. Frequenzumsetzer mit Beseitigung der Spiegelfrequenz nach Anspruch 1, **dadurch gekennzeichnet,** daß der genannte dritte Abschnitt (15) und ein Teil des genannten zweiten Abschnittes (14) der genannten Mikristrip-Leitung (M1) eine offene Stichleitung bilden, deren Länge bei der Frequenz (LO) der örtlichen Taktversorgung 1/4 Lambda beträgt.

3. Frequenzumsetzer mit Beseitigung der Spiegelfrequenz nach Anspruch 1, **dadurch gekennzeichnet,** daß die Breite des ersten und deritten Abschnittes (13,15) der genannten ersten Mikrostrip-Leitung (M1) einen Wert annimmt, bei dem die charakteristische Impedanz der genannten ersten Mikrostrip-Leitung an die aus der Verbindung der beiden Mischer (MIX1,MIX2) mit der genannten ersten und zweiten Leiterbahn (6,7) resultierende Impedanz angepaßt ist.

4. Frequenzumsetzer mit Beseitigung der Spiegelfrequenz nach Anspruch 1, **dadurch gekennzeichnet,** daß das Breitenverhältnis der genannten ersten und zweiten Leiterbahn (6,7) zu derjenigen des genannten ersten und dritten Abschnittes (13,15) des genannten Mikrostrip-Leiters (M1) einen Wert annimmt, der eine Entkoppelung des genannten ersten und dritten Abschnittes (13,15) von der genannten dritten und vierten Leiterbahn (8,9) erlaubt.

5. Frequenzumsetzer mit Beseitigung der Spiegelfrequenz nach Anspruch 1, **dadurch gekennzeichnet,** daß die Breite der genannten dritten und vierten Leiterbahn (8,9) und deren Abstand von der genannten ersten und zweiten Leiterbahn (6,7) einen Wert annimmt, bei dem die charakteristische Impedanz der genannten koplanaren Leiterbahnen (8,6,7,9,6,7) mit derjenigen der genannten zweiten und dritten Mikrostrip-Leitung (M2,M3) identisch ist.

6. Frequenzumsetzer mit Beseitigung der Spiegelfrequenz nach Anspruch 1, **dadurch gekennzeichnet,** daß der genannte Symmetrierübertrager die genannte erste und zweite Leiterbahn (6,7) sowie die genannten ersten, zweiten und dritten Abschnitte (13,14,15) der ersten Mikrostrip-Leitung (M1) mit einschließt, wodurch das mit dem entsprechenden Eingangstor (T1) gekoppelte, gegenüber Erdpotential nicht symmetrische Signal der örtlichen Taktversorgung (LO) an der genannten ersten und zweiten Leiterbahn ansteht, jedoch symmetrisch ist gegenüber Erdpotential.

7. Frequenzumsetzer mit Beseitigung der Spiegelfrequenz nach Anspruch 1, **dadurch gekennzeichnet,** daß die Verbindung der zweiten Anbschlußpunkte der genannten dritten und vierten Leiterbahnen (8,9) mit der genannten zweiten und dritten Mikrostrip-Leitung (M2,M3) über metallisierte Bohrungen (10,11) hergestellt wird.

8. Frequenzumsetzer mit Beseitigung der Spiegelfrequenz nach Anspruch 1, **dadurch gekennzeichnet,** daß die genannten gegenseitig um 90° phasenverschobenen ersten und zweiten RF-Signale an dem ersten und zweiten Tor (T2,T3) des Umsetzers über eine erste im hochfrequenten RF-Gebiet arbeitende 3 dB Quadratur-Koppelschaltung (HYB-RF) sowie ein erstes und zweites Duplexerfilter (FD1, FD2), einschließlich Hochpaßabschnitt (FPA1,FPA2), der RF-Signale sperrt, aber IF-Signale durchläßt, und Tiefpaßabschnitt (FPB1,FPB2), der IF-Signale sperrt, aber RF-Signale durchläßt, ankommen oder abgehen.

9. Frequenzumsetzer mit Beseitigung der Spiegelfrequenz nach Anspruch 8, **dadurch gekennzeichnet,** daß die genannte Quadratur-Koppelschaltung ein erstes Tor (22) besitzt, an dem die hochfrequenten Signale (RF) ankommen oder abgehen, ein zweites Tor (23), das an das erste Tor angrenzt, aber mit einem Abschlußwiderstand (TERM) abgeschlossen ist, sowie ein drittes und viertes Tor (24,25), das jeweils mit dem Hochpaßabschnitt (FPA1,FPA2) der genannten Duplexerfilter (FD1,FD2) verbunden ist, an dem die genannten ersten und zweiten, um 90° phasenverschobenen RF-Signale ankommen oder abgehen.

10. Frequenzumsetzer mit Beseitigung der Spiegelfrequenz nach Anspruch 1, **dadurch gekennzeichnet,** daß die genannten gegenseitig um 90° phasenverschobenen ersten und zweiten IF-Signale an dem ersten und zweiten Tor (T2,T3) des Umsetzers über eine zweite im Zwischenfrequenzgebiet arbeitende 3 dB Quadratur-Koppelschaltung (HYB-IF) und die genannten Duplexerfilter (FD1,FD2) ankommen oder abgehen.

11. Frequenzumsetzer mit Beseitigung der Spiegelfrequenz nach Anspruch 10, **dadurch gekennzeichnet,** daß die genannte 3 dB Quadratur-Koppelschaltung (HYB-IF) ein erstes und zweites Tor (28,29) besitzt, die aneinandergrenzen und an denen ein erstes und/oder zweites IF-Signal (BLI,BLS) ankommt oder abgeht, sowie ein drittes und viertes Tor (26,27), das mit dem Tiefpaßabschnitt (FPB1,FPB2) des genannten Duplexerfilters (FD1,FD2) verbunden ist.

**Revendications**

1. Convertisseur de fréquence à réjection de fréquences-images en technologie coplanaire comprenant:
   - un premier et un second mélangeurs de fréquences (MIX1,MIX2) consistant chacun en une paire de diodes (D1,D2, D3,D4) connectées en série;
   - un port d'entrée (T1) pour un signal d'oscillateur local (LO), un premier (T2) et un deuxième ports (T3) auxquels arrivent, ou desquels partent, un premier et un second signaux radioélectriques respectivement déphasés de 90° l'un par rapport à l'autre et desquels sortent ou auxquels arrivent un premier et/ou un second signal de fréquence intermédiaire également déphasé de 90°;
   - un moyen (M2,M3,8,9,6,7,10,11) qui permet le couplage desdits signaux radioélectriques et signaux de fréquence intermédiaire auxdits premier et second mélangeurs de fréquence (MIX1,MIX2), et
   - une première ligne microruban (M1) faisant partie d'un symétriseur, caractérisée en ce que dans un plan de masse (2) de ladite première ligne microruban (M1) sont réalisées trois zones rectangulaires de longueur égale (3,4,5) sans métallisation et alignées et parallèles à une distance identique l'une par rapport à l'autre et ladite distance formant deux lignes métalliques de dimensions égales (6, 7) entre la zone rectangulaire centrale (4) et les deux zones rectangulaires externes (3,5);

en ce que ladite ligne microruban (M1) comporte une première section (13) placée en prédominance en face d'une première (6) desdites lignes métalliques de dimensions égales (6,7), ladite section joignant le port d'entrée de l'oscillateur local (T1) à une seconde section (14) placée à la moitié de la longueur de ladite première ligne métallique (6) et formant un angle droit avec ladite première section (13), ladite seconde section (14) étant aussi connectée à une troisième section (15) placée à côté d'une seconde (7) desdites lignes métalliques de dimensions égales continuant le sens de ladite première section (13);

en ce que la longueur desdites première et deuxième lignes métalliques (6, 7) est d'une demi-longueur d'onde à la fréquence du signal d'oscillateur local (LO) et en ce que lesdits premier et second mélangeurs de fréquence (MIX1,MIX2) sont connectés au centre desdites première et deuxième lignes (6,7);

en ce que ledit moyen de couplage comporte une troisième et une quatrième (8,9) lignes métalliques placées à l'intérieur de ladite zone centrale (4) sans métallisation, permettant la réalisation de lignes coplanaires avec lesdites première et deuxième lignes (6,7), lesdites troisième et quatrième lignes métalliques ayant des premières extrémités connectées auxdits premier et second mélangeurs de fréquences (MIX1,MIX2) respectivement aux points centraux de la connexion série des diodes (D1,D2 D3,D4) et des secondes extrémités connectées à une seconde et à une troisième lignes microrubans (M2,M3) respectivement joignant lesdites extrémités aux premier et deuxième ports (T2,T3) respectivement dudit convertisseur.

2. Convertisseur de fréquence à réjection de fréquences-images selon la revendication 1, caractérisé en ce que ladite troisième section (15) plus une partie de ladite deuxième section (14) dudit premier microruban (M1) forment un tronçon ouvert d'un quart de longueur d'onde à la fréquence du signal d'oscillateur local (LO).

3. Convertisseur de fréquence à réjection de fréquences-images selon la revendication 1, caractérisé en ce que la largeur des première et troisième sections (13,15) dudit premier microruban (M1) a une valeur permettant de réaliser l'adaptation de l'impédance caractéristique dudit premier microruban avec celle résultant de la connexion des deux mélangeurs (MIX1, MIX2) auxdites première et deuxième lignes (6,7).

4. Convertisseur de fréquence à réjection de fréquences-images selon la revendication 1, caractérisé en ce que le rapport des largeurs desdites première et deuxième lignes (6,7) par rapport à celles desdites première et troisième sections (13,15) desdits microrubans (M1) a une valeur permettant le découplage desdites première et troisième sections (13,15) par rapport auxdites troisième et quatrième lignes (8,9).

5. Convertisseur de fréquence à réjection de fréquences-images selon la revendication 1, caractérisé en ce que les largeurs desdites troisième et quatrième lignes (8,9) et leur distance par rapport auxdites première et deuxième lignes (6,7) ont une valeur permettant de réaliser une impédance caractéristique desdites lignes coplanaires (8,6,7,9,6,7) identique à celle desdits deuxième et troisième microrubans (M2,M3).

6. Convertisseur de fréquence à réjection de fréquences-images selon la revendication 1, caractérisé en ce que ledit symétriseur comporte lesdites première et deuxième lignes (6,7) et lesdites première, deuxième et troisième sections (13,14,15) du premier microruban (M1), permettant à un signal d'oscillateur local (LO), couplé au port d'entrée respectif (T1) non équilibré avec le potentiel de la masse, d'être présent sur lesdites première et deuxième lignes (6,7) équilibré avec le potentiel de la masse.

7. Convertisseur de fréquence à réjection de fréquences-images selon la revendication 1, caractérisé en ce que la connexion desdites secondes extrémités desdites troisième et quatrième lignes métalliques (8,9) auxdites deuxième et troisième lignes microrubans (M2,M3) est réalisée au moyen de trous métallisés (10,11).

8. Convertisseur de fréquence à réjection de fréquences-images selon la revendication 1, caractérisé en ce que lesdits premier et second signaux radioélectriques mutuellement déphasés de 90° atteignent les premier et deuxième ports (T2,T3) du convertisseur ou en sortent au moyen d'un premier circuit de couplage hybride en quadrature de 3dB fonctionnant en fréquence radioélectrique (HYB-RF) et d'un premier et d'un second filtres duplexeurs (FD1,FD2) comportant une section passe-haut (FPA1,FPA2) qui permet le passage des signaux radioélectriques et bloque les signaux de fréquence intermédiaire, et une section passe-bas (FPB1, FPB2) qui permet le passage du signal de fréquence intermédiaire et bloque les signaux radioélectriques.

9. Convertisseur de fréquence à réjection de fréquences-images selon la revendication 8, caractérisé en ce que ledit premier circuit de couplage hybride (HYB-RF) a un premier port (22) auquel arrive ou duquel sort un signal radioélectrique (RF), un deuxième port (23) adjacent au premier et fermé sur une terminaison (TERM), un troisième et un quatrième ports (24,25) connectés aux sections passe-haut (FPA1,FPA2) respectivement desdits filtres duplexeurs (FD1,FD2) auxquels arrivent ou desquels sortent lesdits premier et second signaux radioélectriques mutuellement déphasés de 90°.

10. Convertisseur de fréquence à réjection de fréquences-images selon la revendication 1, caractérisé en ce que lesdits premier et second signaux de fréquence intermédiaire déphasés de 90° atteignent lesdits premier et deuxième ports (T2,T3) du convertisseur ou en sortent au moyen d'un second circuit de couplage hybride en quadrature de 3dB fonctionnant en fréquence intermédiaire (HYB-IF) et desdits filtres duplexeurs (FD1, FD2).

11. Convertisseur de fréquence à réjection de fréquences-images selon la revendication 10, caractérisé en ce que ledit second circuit de couplage hybride en quadrature de 3dB (HYB-IF) a un premier et un deuxième ports (28,29) adjacents l'un par rapport à l'autre et auxquels arrivent ou desquels sortent un premier et/ou un second signal de fréquence intermédiaire (BLI,BLS), un troisième et un quatrième ports (26,27) connectés aux sections passe-bas (FPB1,FPB2) desdits filtres duplexeurs (FD1,FD2).

FIG. 1

FIG. 2